# EUROPEAN PATENT APPLICATION

(11) **EP 4 397 635 A1**
(43) Date of publication of application: **10.07.2024**
(21) Application number: 22864517.2
(22) Date of filing: 29.08.2022
(51) Int. Cl.: C03C 10/04, C03C 21/00

(54) **CRYSTALLIZED GLASS, CHEMICALLY STRENGTHENED GLASS, AND ELECTRONIC DEVICE**

(30) Priority: 02.09.2021 JP 2021143382
(71) Applicant: AGC INC., Chiyoda-ku, Tokyo 1008405 (JP)
(72) Inventor: KANEHARA,Kazuki, Tokyo 100-8405 (JP); KUROIWA,Yutaka, Tokyo 100-8405 (JP); AKIBA, Shusaku, Tokyo 100-8405 (JP)
(74) Representative: Müller-Boré & Partner Patentanwälte PartG mbB
(86) International application number: PCT/JP2022/032464
(87) International publication number: WO 2023/032935

(57) **Abstract**

The present invention relates to crystallized glass that includes lithium disilicate-based crystals and SiO₂-based crystals. In terms of mass, the content of the lithium disilicate-based crystals and the content of the SiO₂-based crystals both are equal to or greater than the content of crystals other than the lithium disilicate-based crystals and the SiO₂-based crystals.

## Description

### TECHNICAL FIELD

The present invention relates to a glass ceramic, a chemically strengthened glass, and an electronic device.

### BACKGROUND ART

A cover glass or the like of a mobile terminal is required to have a strength that does not easily crack even when the mobile terminal is dropped, and therefore, a chemically strengthened glass is widely used. The chemically strengthened glass is a glass obtained by causing ion exchange, by a method such as immersing the glass in a molten salt such as sodium nitrate, between alkali ions contained in the glass and alkali ions contained in the molten salt and having a larger ion radius, thereby forming a compressive stress layer on a surface layer portion of the glass.

The glass ceramic is obtained by precipitating crystals in the glass, and is harder and less likely to be damaged than an amorphous glass containing no crystal. Further, the glass ceramic capable of being chemically strengthened can have high strength while preventing fracturing as compared with an amorphous glass. For example, Patent Literature 1 describes that a glass ceramic containing a predetermined crystal can be chemically strengthened by ion exchange.

In an electronic device such as a communication device such as a mobile phone, a smart phone, a personal digital assistant, or a Wi-Fi device, a surface acoustic wave (SAW) device, a radar component, or an antenna component, a signal frequency has been increased in order to increase a communication capacity, a communication speed, or the like. In recent years, use of 5th generation mobile communication system (5G) as a new communication system using a higher frequency band has been expected. In a high-frequency band used in 5G, the cover glass may interfere with radio wave transmission and reception, and thus a cover glass having excellent radio wave transmittance is required for an electronic device compatible with 5G. That is, a cover glass used for an electronic device such as a mobile terminal is required to be excellent in both strength and radio wave transmittance.

### CITATION LIST

### PATENT LITERATURE

Patent Literature 1: JP2020-33262A

### SUMMARY OF INVENTION

### TECHNICAL PROBLEM

However, in a glass ceramic capable of being chemically strengthened in the related art, a strength thereof can be improved by chemical strengthening, but a characteristic value that affects the radio wave transmittance, such as the relative dielectric constant and the dielectric loss tangent, is likely to be relatively large, and the glass ceramic in the related art is insufficient in terms of the radio wave transmittance. Therefore, it is very difficult to obtain a glass implementing both strength and radio wave transmittance. In addition, the glass ceramic described in Patent Literature 1 can also improve the strength by chemical strengthening, but is not particularly focused on the radio wave transmittance, and is insufficient in terms of radio wave transmittance.

In view of the above problems, an object of the present invention is to provide a glass ceramic that has excellent strength by chemical strengthening and excellent radio wave transmittance. In addition, another object of the present invention is to provide a chemically strengthened glass excellent in both strength and radio wave transmittance.

### SOLUTION TO PROBLEM

The radio wave transmittance of the glass ceramic may be affected by radio wave transmittance of a crystal contained therein. As a result of intensive studies, the present inventors have found that a lithium disilicate-based crystal is very excellent in terms of radio wave transmittance. In addition, it has been found that, in a case where a lithium disilicate-based crystal is mainly precipitated in the glass capable of being chemically strengthened in the related art, other crystals such as petalite which are inferior in terms of radio wave transmittance are simultaneously precipitated, and the radio wave transmittance may not be good. On the other hand, it has been also found that in a case where the glass ceramic contains a lithium disilicate-based crystal and a crystal other than the lithium disilicate-based crystal, excellent radio wave transmittance can be maintained without impairing the radio wave transmittance of the glass ceramic when the crystal other than the lithium disilicate-based crystal is an SiO₂-based crystal.

Therefore, the present inventors have found that the radio wave transmittance of the glass ceramic and the chemically strengthened glass can be improved by increasing a content ratio of the SiO₂-based crystal as a crystal contained in the crystals other than the lithium disilicate-based crystal, while precipitating a relatively large amount of lithium disilicate-based crystals, and have completed the present invention.

That is, the present invention relates to the following 1 to 12.
1. A glass ceramic including:
   a lithium disilicate-based crystal; and
   an SiO₂-based crystal, in which
   a content of the lithium disilicate-based crystal and a content of the SiO₂-based crystal are both equal to or greater than a content of crystal other than the lithium disilicate-based crystal and the SiO₂-based crystal on a mass basis.
2. The glass ceramic according to 1, in which
   the content of the lithium disilicate-based crystal is equal to or greater than the content of the SiO₂-based crystal on a mass basis.
3. The glass ceramic according to 1 or 2, including 20 mass% or more of the lithium disilicate-based crystal.
4. The glass ceramic according to 1 or 2, including 20 mass% or more of the SiO₂-based crystal.
5. The glass ceramic according to 1 or 2, having a degree of crystallinity of 50 mass% or more.
6. The glass ceramic according to 1 or 2, having a relative dielectric constant Dk at 20°C and 10 GHz of 5.4 or less.
7. The glass ceramic according to 1 or 2, having a dielectric loss tangent tan δ at 20°C and 10 GHz of 0.01 or less.
8. The glass ceramic according to 1 or 2, including, in terms of molar percentage based on oxides:
   70% to 80% of SiO₂;
   1% to 5% of Al₂O₃;
   0% to 5.0% of B₂O₃;
   0.5% to 5.0% of P₂O₅;
   0% to 5.0% of TiO₂;
   0% to 1.0% of ZrO₂;
   15% to 25% of Li₂O;
   0% to 5.0% of Na₂O;
   0% to 5.0% of K₂O; and
   0% to 5.0% in total of one or more selected from MgO, CaO, SrO, and BaO.
9. The glass ceramic according to 1 or 2, including, in terms of molar percentage based on oxides:
   70% to 80% of SiO₂;
   1% to 5% of Al₂O₃;
   0% to 5.0% of B₂O₃;
   0.5% to 5.0% of P₂O₅;
   0% to 5.0% of TiO₂;
   0% to 1.0% of ZrO₂;
   15% to 25% of Li₂O;
   0% to 5.0% of Na₂O;
   0% to 5.0% of K₂O;
   0.1% to 10% of a total amount of Na₂O and K₂O; and
   0% to 5.0% in total of one or more selected from MgO, CaO, SrO, and BaO.
10. A chemically strengthened glass having a compressive stress layer on a surface thereof,
   having a surface compressive stress value CS of 25 MPa or more, and
   being the glass ceramic according to 1 or 2.
11. The chemically strengthened glass according to 10, having a sheet shape, in which
   a content ratio of an alkaline metal element is different between a surface layer and a center in a thickness direction.
12. An electronic device including the glass ceramic according to 1.

### ADVANTAGEOUS EFFECTS OF INVENTION

The glass ceramic according to the present invention is adjusted so that a type and a content of a contained crystal satisfy specific requirements, thereby having an excellent strength by chemical strengthening and having excellent radio wave transmittance.

The chemically strengthened glass according to the present invention is a glass ceramic, and is adjusted so that a type and a content of a contained crystal satisfy specific requirements, thereby being excellent in both strength and radio wave transmittance.

### DESCRIPTION OF EMBODIMENTS

In the present description, "to" indicating a numerical range is used in the sense of including the numerical values set forth before and after the "to" as a lower limit value and an upper limit value. Unless otherwise specified, "to" in the present description is used in the same meaning.

In the present description, a "chemically strengthened glass" refers to a glass after a chemical strengthening treatment, and a "glass for chemical strengthening" refers to a glass before the chemical strengthening treatment.

In the present description, "base composition of a chemically strengthened glass" is glass composition of the glass for chemical strengthening. In the chemically strengthened glass, glass composition at a depth of 1/2 of a sheet thickness t is the base composition of the chemically strengthened glass except for a case where an extreme ion exchange treatment is performed.

In the present description, the glass composition is expressed in terms of molar percentage based on oxides unless otherwise specified, and mol% is simply expressed as "%".

In the present description, "substantially free of" means that a component has a content equal to or less than an impurity level contained in raw materials and the like, that is, the component is not intentionally added. Specifically, a content thereof is less than 0.1 mol%, for example.

In the present description, a "stress profile" represents a compressive stress value with a depth from a glass surface as a variable. In addition, a "depth of compressive stress layer (DOL)" is a depth at which the compressive stress value (CS) is zero. An "internal tensile stress value (CT)" refers to a tensile stress value at a depth of 1/2 of the sheet thickness t of the glass.

The stress profile in the present description can be measured using a scattered light photoelastic stress meter (for example, SLP-1000 manufactured by Orihara Industrial Co., Ltd.). In the scattered light photoelastic stress meter, the measurement accuracy in the vicinity of a sample surface may decrease due to an influence of surface scattering. However, for example, when a compressive stress is generated only by ion exchange between lithium ions in the glass and external sodium ions, a stress value of the surface can be obtained by measuring an internal stress value because the compressive stress value represented by a function of the depth follows a complementary error function. In a case of not following the complementary error function, a surface portion is measured by another method, for example, a measurement method with a surface stress meter.

In the present description, an "amorphous glass" and a "glass ceramic" may be collectively referred to simply as a "glass". In the present description, the "amorphous glass" refers to a glass in which a diffraction peak indicating a crystal is not observed by a powder X-ray diffraction method.

In the present description, the "glass ceramic" refers to a glass obtained by subjecting the "amorphous glass" to a heat treatment to precipitate crystals, in which crystals are precipitated in the glass. In the present description, the "glass ceramic" refers to a glass in which a diffraction peak indicating a crystal is observed by X-ray diffraction (XRD). The X-ray diffraction measurement can be performed by, for example, a measurement method using CuKα rays in a range where 2θ is 10° to 80°.

In the present description, the crystal precipitated on the glass ceramic can be identified by powder X-ray diffraction (PXRD) measurement. Further, in order to obtain a more accurate crystal structure, it is preferable to perform Rietveld analysis. According to the Rietveld analysis, quantitative analysis of a crystal phase and an amorphous phase and structural analysis of a crystal phase can be performed. The Rietveld method is described in "Crystal Analysis Handbook" edited by the Crystallographic Society of Japan "Crystal Analysis Handbook" editorial committee (Kyoritsu Shuppan, 1999, p492-499). That is, in the present description, a content, a degree of crystallinity, and the like of each crystal in the glass ceramic are obtained by, for example, Rietveld analysis of an XRD pattern obtained by powder X-ray diffraction (PXRD) measurement.

### (Glass Ceramic)

### (Crystal)

A glass ceramic according to the present embodiment (hereinafter also referred to as "present glass ceramic") includes a lithium disilicate-based crystal and an SiO₂-based crystal. In the present glass ceramic, a content of the lithium disilicate-based crystal and a content of the SiO₂-based crystal are both equal to or greater than a content of crystals other than the lithium disilicate-based crystal and the SiO₂-based crystal on a mass basis.

The present glass ceramic contains a lithium disilicate-based crystal. Specific examples of the lithium disilicate-based crystal include lithium disilicate (Li₂Si₂O₅), Li₂₋ₓNaₓSi₂O₅, and Li₂Si₂₋₃ₓAl₄ₓO₅. That is, the lithium disilicate-based crystal may be a complete lithium disilicate (Li₂Si₂O₅), a lithium disilicate containing defects, or a lithium disilicate in which a heteroelement is dissolved, within a range in which an effect of the present invention is obtained.

The radio wave transmittance of the glass ceramic is improved because the present glass ceramic contains a lithium disilicate-based crystal. From the viewpoint of improving the radio wave transmittance, the content of the lithium disilicate-based crystal in the present glass ceramic is preferably 20 mass% or more, more preferably 25 mass% or more, still more preferably 30 mass% or more, particularly preferably 32.5 mass% or more, further particularly preferably 35 mass% or more, even more preferably 40 mass% or more, and most preferably 45 mass% or more. On the other hand, from the viewpoint of sufficiently introducing a compressive stress by chemical strengthening, the content of the lithium disilicate-based crystal is preferably 70 mass% or less, more preferably 65 mass% or less, still more preferably 60 mass% or less, particularly preferably 57.5 mass% or less, even more preferably 55 mass% or less, and most preferably 52.5 mass% or less. The content of the lithium disilicate-based crystal is preferably 20 mass% to 70 mass%, more preferably 25 mass% to 65 mass%, further preferably 30 mass% to 60 mass%, still more preferably 32.5 mass% to 57.5 mass%, particularly preferably 35 mass% to 55 mass%, further particularly preferably 40 mass% to 52.5 mass%, and even more preferably 45 mass% to 52.5 mass%.

A fact that the glass ceramic contains a lithium disilicate-based crystal can be confirmed from that a peak attributed to a (002) plane is present between 2θ = 36° to 37° in the XRD pattern. In addition, the content of the lithium disilicate-based crystal is determined by the Rietveld analysis described above.

The present glass ceramic contains a SiO₂-based crystal. Specific examples of the SiO₂-based crystal include cristobalite and quartz, and from the viewpoint of the radio wave transmittance, cristobalite is preferable.

The present glass ceramic contains a lithium disilicate-based crystal and a SiO₂-based crystal, and therefore the radio wave transmittance of the glass ceramic is good. From the viewpoint of improving the radio wave transmittance, the content of the SiO₂-based crystal in the present glass ceramic is preferably 20 mass% or more, more preferably 21 mass% or more, still more preferably 22 mass% or more, particularly preferably 23 mass% or more, even more preferably 24 mass% or more, and most preferably 25 mass% or more. From the viewpoint of relatively increasing the content of the lithium disilicate-based crystal, the content of the SiO₂-based crystal is preferably 40 mass% or less, more preferably 38 mass% or less, still more preferably 36 mass% or less, particularly preferably 34 mass% or less, even more preferably 32 mass% or less, and most preferably 30 mass% or less. The content of the SiO₂-based crystal is preferably 20 mass% to 40 mass%, more preferably 21 mass% to 38 mass%, further preferably 22 mass% to 36 mass%, still more preferably 23 mass% to 34 mass%, particularly preferably 24 mass% to 32 mass%, and further particularly preferably 25 mass% to 30 mass%.

It can be confirmed from the XRD pattern that the glass ceramic contains a SiO₂-based crystal. Specifically, a fact that the glass ceramic contains cristobalite can be confirmed from that a peak attributed to a (111) plane which is the strongest peak is present between 2θ = 21.5° to 22.2° in the XRD pattern. A fact that the glass ceramic contains quartz can be confirmed from that a peak attributed to a (101) plane which is the strongest peak is present between 2θ = 26.2° to 26.8° in the XRD pattern. In addition, the content of the SiO₂-based crystal is determined by the Rietveld analysis described above.

The present glass ceramic contains a lithium disilicate-based crystal and a SiO₂-based crystal. The present glass ceramic may arbitrarily contain crystals other than the lithium disilicate-based crystal and the SiO₂-based crystal (hereinafter also referred to as "other crystals").

In the present glass ceramic, the content of the lithium disilicate-based crystal and the content of the SiO₂-based crystal are both equal to or greater than a content of the crystals other than the lithium disilicate-based crystal and the SiO₂-based crystal (other crystals) on a mass basis.

When the glass ceramic contains a plurality of types of other crystals, both the content of the lithium disilicate-based crystal and the content of the SiO₂-based crystal is equal to or greater than a content of each crystal type of the other crystals.

A fact that the present glass ceramic satisfies the above requirements means that the content of the lithium disilicate-based crystal is relatively large and the content of the SiO₂-based crystal is relatively large. That is, the present glass ceramic has excellent radio wave transmittance because the content of the lithium disilicate-based crystal is relatively large. Further, as the crystal contained in a relatively large amount other than the lithium disilicate-based crystal is a SiO₂-based crystal, the radio wave transmittance of the glass ceramic can be improved as a result without impairing the excellent radio wave transmittance derived from the lithium disilicate-based crystal. A reason is considered to be that, in addition to that the lithium disilicate-based crystal is very excellent from the viewpoint of the radio wave transmittance, the SiO₂-based crystal is not as good as the lithium disilicate-based crystal, but has good radio wave transmittance to a certain extent, and does not impair the radio wave transmittance of the glass ceramic.

From the viewpoint of further improving the radio wave transmittance, the content of the lithium disilicate-based crystal is more preferably equal to or greater than the content of the SiO₂-based crystal on a mass basis, and the content of the lithium disilicate-based crystal is still more preferably greater than the content of the SiO₂-based crystal.

When a ratio (mass%) of the content of the lithium disilicate-based crystal is greater than a ratio (mass%) of the content of the SiO₂-based crystal, a difference in the ratios of the contents is preferably 10 mass% or more, more preferably 15 mass% or more, still more preferably 20 mass% or more, particularly preferably 25 mass% or more, further particularly preferably 30 mass% or more, even more preferably 35 mass% or more, and most preferably 40 mass% or more. An upper limit of the difference in contents is not particularly limited, but is, for example, preferably 70 mass% or less, more preferably 65 mass% or less, particularly preferably 60 mass% or less, even more preferably 55 mass% or less, and most preferably 50 mass% or less. The difference in the ratios of the contents is preferably 10 mass% to 70 mass%, more preferably 15 mass% to 65 mass%, further preferably 20 mass% to 60 mass%, still more preferably 25 mass% to 55 mass%, particularly preferably 30 mass% to 50 mass%, further particularly preferably 35 mass% to 50 mass%, and even more preferably 40 mass% to 50 mass%.

From the viewpoint of further improving the radio wave transmittance, the present glass ceramic preferably contains 50 mass% or more in total of the lithium disilicate-based crystal and the SiO₂-based crystal. A total content of the lithium disilicate-based crystal and the SiO₂-based crystal is more preferably 55 mass% or more, still more preferably 60 mass% or more, particularly preferably 65 mass% or more, and even more preferably 70 mass% or more. From the viewpoint of ensuring 3D moldability and from the viewpoint of suppressing an excessive increase in hardness to facilitate polishing, the total content is preferably 90 mass% or less, more preferably 85 mass% or less, still more preferably 80 mass% or less, and particularly preferably 75 mass% or less. The total content of the lithium disilicate-based crystal and the SiO₂-based crystal is preferably 50 mass% to 90 mass%, more preferably 55 mass% to 85 mass%, further preferably 60 mass% to 80 mass%, still more preferably 65 mass% to 75 mass%, and particularly preferably 70 mass% to 75 mass%.

As described above, the present glass ceramic may arbitrarily contain one or more other crystals. Examples of the other crystals include a petalite (LiAlSi₄O₁₀)-based crystal, a spodumene-based crystal, a lithium metasilicate-based crystal, and a eucryptite-based crystal. A fact that the glass ceramic contains, for example, a Petalite-based crystal can be confirmed from that a peak attributed to the (002) plane is present between 2θ = 25° to 26° in the XRD pattern.

The content of the other crystals, for each type of the crystal, is equal to or smaller than the content of the lithium disilicate-based crystal and equal to or smaller than the content of the SiO₂-based crystal. In particular, the Petalite-based crystal, the spodumene-based crystal, or the like are likely to impair the radio wave transmittance of the glass ceramic, and therefore, a content thereof is preferably small.

When the present glass ceramic contains other crystals, specifically, for example, the preferred content thereof for each type of crystal is preferably 30 mass% or less, more preferably 25 mass% or less, still more preferably 20 mass% or less, particularly preferably 18 mass% or less, further particularly preferably 16 mass% or less, even more preferably 14 mass% or less, and most preferably 12 mass% or less, from the viewpoint of improving the radio wave transmittance. The content of the other crystals for each type of crystal is preferably 0 mass% or more, more preferably 1 mass% or more, still more preferably 2 mass% or more, particularly preferably 3 mass% or more, further particularly preferably 4 mass% or more, even more preferably 5 mass% or more, still even more preferably 6 mass% or more, and most preferably 7 mass% or more, from the viewpoint of increasing the hardness of the glass. The content of the other crystals for each type of crystal is preferably 0 mass% to 30 mass%, more preferably 1 mass% to 25 mass%, further preferably 2 mass% to 20 mass%, still more preferably 3 mass% to 18 mass%, particularly preferably 4 mass% to 16 mass%, further particularly preferably 5 mass% to 14 mass%, even more preferably 6 mass% to 12 mass%, and most preferably 7 mass% to 12 mass%.

In addition, a total content of the other crystals is preferably 30 mass% or less, more preferably 25 mass% or less, still more preferably 20 mass% or less, particularly preferably 18 mass% or less, further particularly preferably 16 mass% or less, even more preferably 14 mass% or less, and most preferably 12 mass% or less, from the viewpoint of improving the radio wave transmittance. The total content of the other crystals is preferably 0 mass% or more, more preferably 1 mass% or more, still more preferably 2 mass% or more, particularly preferably 3 mass% or more, further particularly preferably 4 mass% or more, even more preferably 5 mass% or more, still even more preferably 6 mass% or more, and most preferably 7 mass% or more, from the viewpoint of increasing the hardness of the glass. The total content of the other crystals is preferably 0 mass% to 30 mass%, more preferably 1 mass% to 25 mass%, further preferably 2 mass% to 20 mass%, still more preferably 3 mass% to 18 mass%, particularly preferably 4 mass% to 16 mass%, further particularly preferably 5 mass% to 14 mass%, even more preferably 6 mass% to 12 mass%, and most preferably 7 mass% to 12 mass%.

The degree of crystallinity of the present glass ceramic is preferably 50 mass% or more, more preferably 55 mass% or more, still more preferably 60 mass% or more, particularly preferably 65 mass% or more, even more preferably 70 mass% or more, and most preferably 75 mass% or more, from the viewpoint of improving the radio wave transmittance and increasing the strength of the glass. The degree of crystallinity is preferably 90 mass% or less, more preferably 87.5 mass% or less, still more preferably 85 mass% or less, particularly preferably 82.5 mass% or less, and even more preferably 80 mass% or less, from the viewpoint of sufficiently providing a compressive stress by chemical strengthening or enhancing the 3D moldability. The degree of crystallinity is preferably 50 mass% to 90 mass%, more preferably 55 mass% to 90 mass%, further preferably 60 mass% to 87.5 mass%, still more preferably 65 mass% to 85 mass%, particularly preferably 70 mass% to 82.5 mass%, and further particularly preferably 75 mass% to 80 mass%. The degree of crystallinity is a sum of precipitation ratios of the respective crystals in the glass ceramic, and is a sum of the content ratios of the lithium disilicate-based crystal, the SiO₂-based crystal, and the other crystals.

In the present glass ceramic, a ratio of an amorphous phase is preferably 30 mass% or less, more preferably 28 mass% or less, still more preferably 26 mass% or less, particularly preferably 25 mass% or less, further particularly preferably 24 mass% or less, even more preferably 23 mass% or less, and most preferably 22 mass% or less, from the viewpoint of improving the radio wave transmittance. The ratio of the amorphous phase is preferably 10 mass% or more, more preferably 12 mass% or more, still more preferably 14 mass% or more, particularly preferably 15 mass% or more, even more preferably 16 mass% or more, and most preferably 18 mass% or more, from the viewpoint of sufficiently providing a compressive stress by chemical strengthening or enhancing the 3D moldability. The ratio of the amorphous phase is preferably 10 mass% to 30 mass%, more preferably 12 mass% to 28 mass%, further preferably 14 mass% to 26 mass%, still more preferably 15 mass% to 25 mass%, particularly preferably 16 mass% to 24 mass%, further particularly preferably 18 mass% to 23 mass%, and even more preferably 18 mass% to 22 mass%. Here, in the present description, the amorphous phase refers to a value obtained by subtracting a total sum (mass%) of the ratios of crystal amounts obtained by Rietveld analysis from 100 mass%.

In the present glass ceramic, an average particle size of a precipitated crystal is preferably 5 nm to 80 nm. The average particle size of the precipitated crystal is preferably 80 nm or less, more preferably 70 nm or less, further preferably 60 nm or less, still more preferably 50 nm or less, particularly preferably 40 nm or less, and most preferably 30 nm or less from the viewpoint of improving the transparency. The average particle size of the precipitated crystal is, for example, preferably 5 nm or more, more preferably 6 nm or more, still more preferably 7 nm or more, particularly preferably 8 nm or more, even more preferably 9 nm or more, and most preferably 10 nm or more in order to increase the strength. The average particle size of the precipitated crystal is determined from a transmission electron microscope (TEM) image. The average particle size of the precipitated crystal can be estimated from a scanning electron microscope (SEM) image.

### (Composition of glass ceramic)

Glass composition of the present glass ceramic is the same as glass composition of the amorphous glass before crystallization in a production method to be described later. Therefore, preferred aspects of the glass composition of the present glass ceramic and the glass composition of the amorphous glass are the same. Here, the composition of the glass ceramic in the present description refers to the total composition of the crystal phase and the amorphous phase of the glass ceramic. The glass composition of the glass ceramic is determined by subjecting the glass ceramic to a heat treatment at a temperature equal to or higher than a melting point and analyzing the vitrified glass. Examples of an analysis method include a fluorescent X-ray analysis method.

The glass composition of the present glass ceramic is not particularly limited, but an example of a preferred aspect is as follows. In the glass composition of the present glass ceramic, a lower limit of a preferred content of a non-essential component is 0%.

The present glass ceramic is preferably a lithium silicate glass containing SiO₂ and Li₂O or a lithium aluminosilicate glass containing SiO₂, Al₂O₃, and Li₂O, and more preferably a lithium aluminosilicate glass. Since the lithium silicate glass and the lithium aluminosilicate glass contain lithium ions which are alkali ions having the smallest ion radius, a chemically strengthened glass having a preferred stress profile is easily obtained by a chemical strengthening treatment in which ion exchange is performed using various molten salts.

In order to obtain a glass ceramic having a relatively large content of the lithium disilicate-based crystal and the SiO₂-based crystal, the glass composition preferably has the following features.

First, it is known that the lithium disilicate-based crystal contains P₂O₅ as a crystal nucleus. Therefore, the present glass ceramic preferably contains P₂O₅, but does not contain components ZrO₂ and TiO₂ which may be a crystal nucleus of the other crystals, or has a small contents of these components.

Second, in order to suppress precipitation of the other crystals and to relatively increase the content of the SiO₂-based crystal, it is preferable that the content of Al₂O₃ is relatively small and the content of SiO₂ is relatively large.

Hereinafter, the glass composition of the present glass ceramic will be described more specifically.

SiO₂ is a component that constitutes a lithium disilicate-based crystal and a SiO₂-based crystal, and is an essential component. SiO₂ is a component that constitutes a glass network and is also a component that improves chemical durability. A content of SiO₂ is preferably 70% to 80%. The content of SiO₂ is preferably 70% or more, more preferably 71% or more, still more preferably 72% or more, particularly preferably 73% or more, even more preferably 74% or more, and most preferably 74.5% or more, from the viewpoint of precipitating the lithium disilicate-based crystal and the SiO₂-based crystal and from the viewpoint of improving the chemical durability. The content of SiO₂ is preferably 80% or less, more preferably 79% or less, still more preferably 78% or less, particularly preferably 77% or less, even more preferably 76% or less, and most preferably 75.5% or less in order to improve meltability during glass production.

Al₂O₃ is not essential, but is an effective component from the viewpoint of improving ion exchange performance during chemical strengthening and increasing the surface compressive stress after strengthening. Al₂O₃ is also a component that improves the chemical durability. A content of Al₂O₃ is preferably 0% to 5%, and more preferably 1% to 5%. The content of Al₂O₃ is preferably 1% or more, more preferably 1.5% or more, still more preferably 2% or more, particularly preferably 2.5% or more, further particularly preferably 3% or more, even more preferably 3.5% or more, and most preferably 4% or more in order to improve the chemical durability and in order to improve chemical strengthening properties. The content of Al₂O₃ is preferably 5% or less, more preferably 4.9% or less, still more preferably 4.8% or less, particularly preferably 4.7% or less, further particularly preferably 4.6% or less, even more preferably 4.5% or less, and most preferably 4.4% or less, from the viewpoint of suppressing precipitation of the other crystals.

A ratio (Al₂O₃/SiO₂) of the content of Al₂O₃ to the content of SiO₂ is preferably 0 to 0.06. (Al₂O₃/SiO₂) is preferably 0.06 or less, more preferably 0.058 or less, further preferably 0.055 or less, still more preferably 0.05 or less, particularly preferably 0.0475 or less, further particularly preferably 0.045 or less, even more preferably 0.0425 or less, and most preferably 0.04 or less, from the viewpoint of suppressing precipitation of the other crystals. (Al₂O₃/SiO₂) is preferably 0 or more, more preferably 0.01 or more, still more preferably 0.015 or more, particularly preferably 0.02 or more, even more preferably 0.025 or more, and most preferably 0.03 or more, from the viewpoint of sufficiently providing a compressive stress by chemical strengthening.

Li₂O is a component that constitutes a lithium disilicate-based crystal, and is an essential component. Li₂O is a component that forms a surface compressive stress by ion exchange, and is also a component that improves the meltability of the glass. When the glass ceramic contains Li₂O, a stress profile with a large surface compressive stress and a large compressive stress layer is obtained by a method of ion-exchanging Li ions on the glass surface to Na ions, and further ion-exchanging Na ions to K ions. A content of Li₂O is preferably 15% to 25%. The content of Li₂O is preferably 15% or more, more preferably 15.5% or more, still more preferably 16% or more, particularly preferably 16.5% or more, further particularly preferably 17% or more, even more preferably 17.5% or more, and most preferably 18% or more, from the viewpoint of precipitating a lithium disilicate-based crystal and from the viewpoint of improving the strength by chemical strengthening. On the other hand, the content of Li₂O is preferably 25% or less, more preferably 24% or less, still more preferably 23% or less, particularly preferably 22% or less, even more preferably 21% or less, and most preferably 20% or less, in order to stabilize the glass.

Na₂O and K₂O are not essential components, but are components that improve the meltability of the glass and are also components that improve the ion exchange performance. In order to obtain these effects, the present glass ceramic may contain at least one of Na₂O and K₂O.

Na₂O is a component that forms a surface compressive stress layer in a chemical strengthening treatment using a potassium salt, and is a component that may improve the meltability of the glass. A content of Na₂O is preferably 0% to 5.0%. When the present glass ceramic contains Na₂O, the content thereof is preferably 0.1% or more, more preferably 0.3% or more, still more preferably 0.5% or more, particularly preferably 0.7% or more, even more preferably 1.0% or more, and most preferably 1.2% or more. On the other hand, in a case where the content of Na₂O is extremely large, it may be difficult to increase a compressive stress of a portion relatively deep from the surface by chemical strengthening. From such a viewpoint, the content of Na₂O is preferably 5.0% or less, more preferably 4.5% or less, still more preferably 4.0% or less, particularly preferably 3.5% or less, even more preferably 3.0% or less, and most preferably 2.5% or less.

K₂O is a component that improves the meltability of the glass and is also a component that improves the ion exchange performance. A content of K₂O is preferably 0% to 5.0%. When the present glass ceramic contains K₂O, the content thereof is preferably 0.1% or more, more preferably 0.15% or more, still more preferably 0.2% or more, and particularly preferably 0.25% or more, from the viewpoint of obtaining the effects. The content of K₂O is preferably 5.0% or less, more preferably 4.0% or less, still more preferably 3.0% or less, particularly preferably 2.0% or less, further particularly preferably 1.5% or less, even more preferably 1.0% or less, and most preferably 0.5% or less, from the viewpoint of suppressing a decrease in chemical strengthening properties and chemical durability.

A total content of Na₂O and K₂O is preferably 0% to 10%, and more preferably 0.1% to 10%. When the present glass ceramic contains at least one of Na₂O and K₂O, the total content of Na₂O and K₂O is preferably 0.1% or more, more preferably 0.3% or more, still more preferably 0.5% or more, particularly preferably 0.7% or more, even more preferably 1.0% or more, and most preferably 1.2% or more, from the viewpoint of improving the meltability of the glass and the viewpoint of improving the ion exchange performance. The total content of Na₂O and K₂O is preferably 10% or less, more preferably 9.0% or less, further preferably 8.0% or less, still more preferably 7.0% or less, particularly preferably 6.0% or less, further particularly preferably 5.0% or less, even more preferably 4.0% or less, and most preferably 3.0% or less, from the viewpoint of suppressing a decrease in chemical strengthening properties and chemical durability.

MgO, CaO, SrO, and BaO are not essential components, but are components that may enhance the stability of the glass and are components that may improve the chemical strengthening properties. The present glass ceramic may contain one or more selected from MgO, CaO, SrO, and BaO. A total amount of one or more selected from MgO, CaO, SrO, and BaO is preferably 0% to 5.0%. When these components are contained, the total amount of one or more selected from MgO, CaO, SrO, and BaO is preferably 0.1% or more, more preferably 0.3% or more, still more preferably 0.5% or more, particularly preferably 0.7% or more, even more preferably 1.0% or more, and most preferably 1.2% or more. The total content thereof is preferably 5.0% or less, more preferably 4.5% or less, still more preferably 4.0% or less, particularly preferably 3.5% or less, even more preferably 3.0% or less, and most preferably 2.5% or less, from the viewpoint of providing a sufficient compressive stress during chemical strengthening and from the viewpoint of enhancing the radio wave transmittance.

The present glass ceramic may contain MgO in order to lower the viscosity during melting or the like. A content of MgO is preferably 0% to 5.0%. When the present glass ceramic contains MgO, the content of MgO is preferably 0.1% or more, more preferably 0.3% or more, still more preferably 0.5% or more, particularly preferably 0.7% or more, even more preferably 1.0% or more, and most preferably 1.2% or more. The content of MgO is preferably 5.0% or less, more preferably 4.5% or less, still more preferably 4.0% or less, particularly preferably 3.5% or less, even more preferably 3.0% or less, and most preferably 2.5% or less, from the viewpoint of suppressing deterioration of chemical strengthening properties.

CaO is a component that improves the meltability of the glass. The present glass ceramic may contain CaO. A content of CaO is preferably 0% to 5.0%. When the present glass ceramic contains CaO, the content of CaO is preferably 0.1% or more, more preferably 0.3% or more, still more preferably 0.5% or more, particularly preferably 0.7% or more, even more preferably 1.0% or more, and most preferably 1.2% or more. The content of CaO is preferably 5.0% or less, more preferably 4.5% or less, still more preferably 4.0% or less, particularly preferably 3.5% or less, even more preferably 3.0% or less, and most preferably 2.5% or less, from the viewpoint of suppressing deterioration of chemical strengthening properties.

ZnO is not an essential component, but is a component that may improve the meltability of the glass. The present glass ceramic may contain ZnO. A content of ZnO is preferably 0% to 5.0%. When the present glass ceramic contains ZnO, the content of ZnO is preferably 0.1% or more, more preferably 0.3% or more, still more preferably 0.5% or more, particularly preferably 0.7% or more, even more preferably 1.0% or more, and most preferably 1.2% or more. The content of ZnO is preferably 5.0% or less, more preferably 4.5% or less, still more preferably 4.0% or less, particularly preferably 3.5% or less, even more preferably 3.0% or less, and most preferably 2.5% or less, from the viewpoint of improving the weather resistance.

A total content [ZnO] + [SrO] + [BaO] of ZnO, SrO, and BaO is preferably 0% to 5.0%. ZnO, SrO, and BaO tend to deteriorate the chemical strengthening properties, and in order to facilitate chemical strengthening, [ZnO] + [SrO] + [BaO] is preferably 5.0% or less, more preferably 4.5% or less, still more preferably 4.0% or less, particularly preferably 3.5% or less, even more preferably 3.0% or less, and most preferably 2.5% or less. On the other hand, when these components are contained, the total content thereof is preferably 0.1% or more, more preferably 0.3% or more, still more preferably 0.5% or more, particularly preferably 0.7% or more, even more preferably 1.0% or more, and most preferably 1.2% or more.

P₂O₅ is a component serving as a crystal nucleus of the lithium disilicate-based crystal. A content of P₂O₅ is preferably 0.5% to 5.0%. The content of P₂ O₅ is preferably 0.5% or more, more preferably 0.6% or more, still more preferably 0.7% or more, particularly preferably 0.8% or more, further particularly preferably 0.9% or more, even more preferably 1.0% or more, still even more preferably 1.1% or more, and most preferably 1.2% or more, from the viewpoint of precipitating the lithium disilicate-based crystal. The content of P₂O₅ is preferably 5.0% or less, more preferably 4.5% or less, still more preferably 4.0% or less, particularly preferably 3.5% or less, further particularly preferably 3.0% or less, even more preferably 2.5% or less, still even more preferably 2.0% or less, and most preferably 1.5% or less, from the viewpoint of increasing acid resistance.

TiO₂ is a component that may suppress solarization of glass, and is also a component that may be a nucleus of other crystals. A content of TiO₂ is preferably 0% to 5.0%. The content of TiO₂ is preferably 5.0% or less, more preferably 4.5% or less, still more preferably 4.0% or less, particularly preferably 3.5% or less, even more preferably 3.0% or less, and most preferably 2.5% or less, from the viewpoint of suppressing precipitation of the other crystals. The present glass ceramic may be substantially free of TiO₂. When the present glass ceramic contains TiO₂, the content of TiO₂ is preferably 0.1% or more, more preferably 0.3% or more, still more preferably 0.5% or more, particularly preferably 0.7% or more, even more preferably 1.0% or more, and most preferably 1.2% or more.

ZrO₂ is a component that may increase the surface compressive stress of the chemically strengthened glass, and is also a component that may be a nucleus of other crystals. A content of ZrO₂ is preferably 0% to 1.0%. The content of ZrO₂ is preferably 1.0% or less, more preferably 0.9% or less, still more preferably 0.8% or less, particularly preferably 0.7% or less, even more preferably 0.6% or less, and most preferably 0.5% or less, from the viewpoint of suppressing precipitation of the other crystals. The present glass ceramic may be substantially free of ZrO₂. When the present glass ceramic contains ZrO₂, the content of ZrO₂ is preferably 0.1% or more, more preferably 0.2% or more, still more preferably 0.3% or more, and particularly preferably 0.4% or more.

When the present glass ceramic contains at least one of TiO₂ and ZrO₂, a ratio (TiO₂ + ZrO₂)/P₂O₅ of a total content of TiO₂ and ZrO₂ to the content of P₂O₅ is preferably 0 to 2.0. (TiO₂ + ZrO₂)/P₂O₅ is preferably 2.0 or less, more preferably 1.8 or less, still more preferably 1.6 or less, particularly preferably 1.4 or less, and even more preferably 1.2 or less, from the viewpoint of suppressing precipitation of the other crystals. (TiO₂ + ZrO₂)/P₂O₅ is preferably 0 or more, more preferably 0.1 or more, still more preferably 0.2 or more, particularly preferably 0.3 or more, further particularly preferably 0.4 or more, even more preferably 0.5 or more, and most preferably 0.6 or more, from the viewpoint of reducing a size of the crystal.

B₂O₃ is not an essential component, but is a component that may reduce brittleness of the glass and improve crack resistance, and is a component that may improve the radio wave transmittance. The present glass ceramic may contain B₂O₃. A content of B₂O₃ is preferably 0% to 5.0%. When the present glass ceramic contains B₂O₃, the content thereof is preferably 0.2% or more, more preferably 0.4% or more, still more preferably 0.6% or more, particularly preferably 0.8% or more, even more preferably 1.0% or more, and most preferably 1.2% or more. The content of B₂O₃ is preferably 5.0% or less, more preferably 4.5% or less, still more preferably 4.0% or less, particularly preferably 3.5% or less, even more preferably 3.0% or less, and most preferably 2.5% or less, from the viewpoint of increasing the acid resistance.

Nb₂O₅, Ta₂O₅, Gd₂O₃, and CeO₂ are components that suppress solarization of the glass and are components that improve the meltability. The present glass ceramic may contain at least one or more of these components. A total content of these components is preferably 0% to 3%. When the present glass ceramic contains these components, a total content thereof is preferably 0.03% or more, more preferably 0.1% or more, still more preferably 0.3% or more, particularly preferably 0.5% or more, even more preferably 0.8% or more, and most preferably 1% or more. On the other hand, in a case where the content of these components is extremely large, it is difficult to increase the compressive stress value during the chemical strengthening treatment. From such a viewpoint, the total content of these components is preferably 3% or less, more preferably 2.5% or less, still more preferably 2% or less, particularly preferably 1.5% or less, even more preferably 1% or less, and most preferably 0.5% or less.

Fe₂O₃ is a component that may improve the glass solubility by absorbing heat rays. A content of Fe₂O₃ is preferably 0% to 0.3% in terms of weight% based on an oxide. When the glass is mass-produced using a large melting furnace, the present glass ceramic preferably contains Fe₂O₃. In this case, the content of Fe₂O₃ is preferably 0.002% or more, more preferably 0.003% or more, still more preferably 0.005% or more, particularly preferably 0.007% or more, even more preferably 0.008% or more, and most preferably 0.01% or more, in terms of weight% based on the oxide. On the other hand, in a case where Fe₂O₃ is excessively contained, coloring occurs, and thus the content thereof is preferably 0.3% or less, more preferably 0.04% or less, still more preferably 0.03% or less, particularly preferably 0.025% or less, even more preferably 0.02% or less, and most preferably 0.015% or less, in terms of weight% based on the oxide from the viewpoint of increasing the transparency of the glass.

Here, all iron oxides in the glass have been described as Fe₂O₃, but actually, Fe(III) in an oxidized state and Fe(II) in a reduced state are mixed generally. Among them, Fe(III) causes yellow coloring, Fe(II) causes blue coloring, and green coloring occurs in the glass depending on the balance therebetween.

Further, the present glass ceramic may contain a coloring component within a range not impairing the effects of the present invention. Preferred examples of the coloring component include Co₃O₄, MnO₂, NiO, CuO, Cr₂O₃, V₂O₅, Bi₂O₃, SeO₂, CeO₂, Er₂O₃, and Nd₂O₃.

A content of the coloring component is preferably 5% or less, more preferably 4% or less, still more preferably 3% or less, particularly preferably 2% or less, and even more preferably 1% or less in total in terms of molar percentage based on oxides. When it is desired to increase the transmittance of the glass, the present glass ceramic is preferably substantially free of these components.

SO₃, a chloride, a fluoride, or the like may be appropriately contained as a refining agent or the like during melting of the glass. As₂O₃ is preferably not contained. In a case where Sb₂O₃ is contained, a content thereof is preferably 0.3% or less, more preferably 0.1% or less, and most preferably not contained.

Specific examples of preferred glass composition of the present glass ceramic include, but are not limited to, the following.

A glass ceramic includes, in terms of molar percentage based on oxides:
70% to 80% of SiO₂;
1% to 5% of Al₂O₃;
0% to 5.0% of B₂O₃;
0.5% to 5.0% of P₂O₅;
0% to 5.0% of TiO₂;
0% to 1.0% of ZrO₂;
15% to 25% of Li₂O;
0% to 5.0% of Na₂O;
0% to 5.0% of K₂O; and
0% to 5.0% in total of one or more selected from MgO, CaO, SrO, and BaO.

In addition, the following glass composition is more preferable from the viewpoint of further improving the chemical strengthening properties.

A glass ceramic includes, in terms of molar percentage based on oxides:
70% to 80% of SiO₂;
1% to 5% of Al₂O₃;
0% to 5.0% of B₂O₃;
0.5% to 5.0% of P₂O₅;
0% to 5.0% of TiO₂;
0% to 1.0% of ZrO₂;
15% to 25% of Li₂O;
0% to 5.0% of Na₂O;
0% to 5.0% of K₂O;
0.1% to 10% of a total amount of Na₂O and K₂O; and
0% to 5.0% in total of one or more selected from MgO, CaO, SrO, and BaO.

### (Physical Properties)

A relative dielectric constant Dk of the present glass ceramic at 20°C and 10 GHz is preferably 5.4 or less, more preferably 5.3 or less, still more preferably 5.2 or less, particularly preferably 5.15 or less, further particularly preferably 5.1 or less, even more preferably 5.05 or less, still even more preferably 5.0 or less, and most preferably 4.95 or less. When the relative dielectric constant Dk is small, loss of radio waves due to reflection on the glass surface can be suppressed, and thus the radio wave transmittance is likely to be good. A lower limit of the relative dielectric constant is not particularly limited, but is typically 4.0 or more. The relative dielectric constant Dk may be, for example, 4.0 to 5.4.

A dielectric loss tangent tan δ of the present glass ceramic at 20°C and 10 GHz is preferably 0.01 or less, more preferably 0.009 or less, still more preferably 0.008 or less, particularly preferably 0.007 or less, further particularly preferably 0.006 or less, even more preferably 0.0055 or less, and most preferably 0.005 or less. When the dielectric loss tangent tan δ is small, the loss when the radio wave passes through the inside of the glass can be suppressed, and thus the radio wave transmittance is likely to be good. A lower limit of the dielectric loss tangent is not particularly limited, but is typically 0.0005 or more. The dielectric loss tangent tan δ may be, for example, 0.0005 to 0.01.

It is preferable that values of the relative dielectric constant and the dielectric loss tangent at 20°C and 10 GHz and values of the relative dielectric constant and the dielectric loss tangent at higher frequencies are brought close to each other to reduce the frequency dependence (dielectric dispersion), whereby the frequency properties of the dielectric properties are less likely to change and the design change is small even when the frequencies at the time of use are different.

In the present glass ceramic, the content of the lithium disilicate-based crystal and the content of the SiO₂-based crystal are relatively large, whereby the relative dielectric constant Dk and the dielectric loss tangent tan δ at 20°C and 10 GHz are small. It is particularly easy for the lithium disilicate-based crystal to reduce the relative dielectric constant Dk, and it is easy for the present glass ceramic to reduce the relative dielectric constant Dk.

In general, the frequency dependence of the relative dielectric constant and the dielectric loss tangent of the glass is small in a frequency range of about 10 GHz to 40 GHz, and thus the present glass having excellent dielectric properties at 10 GHz is excellent in radio wave transmittance even in bands such as 28 GHz and 35 GHz used in 5G.

The relative dielectric constant and the dielectric loss tangent can be measured by a slip post dielectric resonance method (SPDR method) using a network analyzer.

The glass ceramic contains crystals and thus has high hardness. Therefore, the glass ceramic is less likely to be damaged and is excellent in wear resistance. The Vickers hardness is preferably 600 to 1,100. In order to increase the wear resistance, the Vickers hardness is preferably 600 or more, more preferably 650 or more, still more preferably 700 or more, particularly preferably 730 or more, even more preferably 750 or more, and most preferably 780 or more.

In a case where the hardness is extremely high, processing tends to be difficult, and therefore, the Vickers hardness of the glass ceramic is preferably 1,100 or less, more preferably 1,080 or less, still more preferably 1,060 or less, particularly preferably 1,050 or less, even more preferably 1,030 or less, and most preferably 1,000 or less.

The Young's modulus of the glass ceramic is preferably 85 GPa to 130 GPa. The Young's modulus is preferably 85 GPa or more, more preferably 90 GPa or more, still more preferably 93 GPa or more, particularly preferably 95 GPa or more, even more preferably 97 GPa or more, and most preferably 100 GPa or more, in order to suppress warpage due to strengthening during chemical strengthening. The glass ceramic may be used after being polished. For ease of polishing, the Young's modulus is preferably 130 GPa or less, more preferably 127 GPa or less, still more preferably 125 GPa or less, particularly preferably 123 GPa or less, and even more preferably 120 GPa or less.

It is preferable that a fracture toughness value of the glass ceramic is preferably 0.8 MPa·m^{1/2} or more, more preferably 0.83 MPa·m^{1/2} or more, still more preferably 0.85 MPa·m^{1/2} or more, particularly preferably 0.87 MPa·m^{1/2} or more, and even more preferably 0.9 MPa·m^{1/2} or more, because broken pieces at the time of cracking are less likely to scatter when the glass ceramic is chemically strengthened. An upper limit of the fracture toughness value is not particularly limited, but is typically 1.5 MPa·m^{1/2} or less. The fracture toughness value may be, for example, 0.8 MPa·m^{1/2} to 1.5 MPa·m^{1/2}.

### (Shape)

A shape of the present glass ceramic is not particularly limited, but is preferable, for example, a sheet shape. When the present glass ceramic has a sheet shape (glass sheet), a sheet thickness (t) thereof is preferably, for example, 0.1 mm to 2 mm. The sheet thickness (t) is, for example, 2 mm or less, preferably 1.5 mm or less, more preferably 1 mm or less, still more preferably 0.9 mm or less, particularly preferably 0.8 mm or less, even more preferably 0.7 mm or less, and most preferably 0.6 mm or less, from the viewpoint of enhancing the chemical strengthening effect. In addition, the sheet thickness is, for example, preferably 0.1 mm or more, more preferably 0.2 mm or more, further preferably 0.3 mm or more, still more preferably 0.35 mm or more, particularly preferably 0.4 mm or more, and further particularly preferably 0.5 mm or more, from the viewpoint of obtaining an effect of sufficiently improving the strength by the chemical strengthening treatment.

The shape of the present glass ceramic may be a shape other than a sheet shape depending on a product to be applied, an application, or the like. In addition, the glass sheet may have an edged shape or the like in which a thickness of an outer periphery is different. In addition, a form of the glass sheet is not limited thereto, and for example, two main surfaces may not be parallel to each other. In addition, one or both of the two main surfaces may be entirely or partially curved. More specifically, the glass sheet may be, for example, a flat glass sheet having no warpage or a curved glass sheet having a curved surface.

### (Chemically Strengthened Glass)

A chemically strengthened glass according to an embodiment of the present invention (hereinafter, also referred to as "present chemically strengthened glass") is obtained by chemically strengthening the present glass ceramic described above. That is, a base composition of the present chemically strengthened glass is the same as the glass composition of the present glass ceramic described above, and a preferred composition range is also the same. When the chemically strengthened glass has, for example, a sheet shape, a content ratio of an alkaline metal element differs between a surface layer and a center in the thickness direction. On the other hand, the glass composition in the deepest portion from the surface of the chemically strengthened glass is the same as the base composition of the chemically strengthened glass except for a case where extreme ion exchange treatment is performed. When the chemically strengthened glass has a sheet shape, the deepest portion from the glass surface is, for example, a depth of 1/2 of the sheet thickness t.

The present chemically strengthened glass is, for example, a chemically strengthened glass including a compressive stress layer on a surface thereof, has a surface compressive stress value CS of 25 MPa or more, and is preferably a chemically strengthened glass which is the present glass ceramic described above.

The strength can be improved by chemically strengthening the present glass ceramic. Further, the crystals contained in the present chemically strengthened glass and contents thereof are the same as those of the present glass ceramic except for the case where the extreme ion exchange treatment or the like is performed. That is, the present chemically strengthened glass is excellent in radio wave transmittance for the same reason as the present glass ceramic. In addition, the present chemically strengthened glass is excellent in both strength and radio wave transmittance.

The present chemically strengthened glass preferably has a surface compressive stress value CS of 25 MPa to 300 MPa. CS is preferably 25 MPa or more, more preferably 30 MPa or more, still more preferably 35 MPa or more, particularly preferably 40 MPa or more, even more preferably 45 MPa or more, and most preferably 50 MPa or more.

The larger the surface compressive stress value CS is, the higher the strength, but in a case where the surface compressive stress value CS is extremely large, a large tensile stress is generated inside the chemically strengthened glass, and there is a concern that breakage may occur. From such a viewpoint, the surface compressive stress value CS is preferably 300 MPa or less, more preferably 250 MPa or less, still more preferably 200 MPa or less, particularly preferably 150 MPa or less, even more preferably 100 MPa or less, and most preferably 75 MPa or less.

In a stress profile of the present chemically strengthened glass, the compressive stress value CS₅₀ at a depth of 50 µm from the surface is preferably 5 MPa to 100 MPa. CS₅₀ is preferably 5 MPa or more, more preferably 10 MPa or more, particularly preferably 15 MPa or more, even preferably 20 MPa or more, and most preferably 25 MPa or more. When CS₅₀ is large, the chemically strengthened glass is hardly cracked at the time of being damaged by dropping or the like. CS₅₀ is preferably 100 MPa or less, more preferably 90 MPa or less, still more preferably 80 MPa or less, particularly preferably 70 MPa or less, further particularly preferably 60 MPa or less, even more preferably 50 MPa or less, and most preferably 40 MPa or less, from the viewpoint of preventing severe crushing.

An internal tensile stress value CT of the present chemically strengthened glass is preferably 5 MPa to 100 MPa. CT is preferably 100 MPa or less, more preferably 75 MPa or less, still more preferably 50 MPa or less, particularly preferably 40 MPa or less, even more preferably 30 MPa or less, and most preferably 20 MPa or less. When CT is small, crushing is less likely to occur. The internal tensile stress value CT is preferably 5 MPa or more, more preferably 10 MPa or more, particularly preferably 15 MPa or more, and even more preferably 17.5 MPa or more. When the CT is equal to or greater than the above value, a compressive stress in the vicinity of the surface increases, and the strength increases.

A depth of a compressive stress layer DOL of the present chemically strengthened glass is preferably 0.04t to 0.22t with respect to the thickness t (mm). In a case where DOL is extremely large with respect to the thickness t (mm), CT increases, and therefore, DOL is preferably 0.22t or less, further preferably 0.21t or less, still more preferably 0.20t or less, particularly preferably 0.19t or less, further particularly preferably 0.18t or less, even more preferably 0.16t or less, still even more preferably 0.14t or less, and most preferably 0.12t or less. In addition, DOL is preferably 0.04t or more, more preferably 0.05t or more, particularly preferably 0.06t or more, even more preferably 0.07t or more, still even more preferably 0.08t or more, and most preferably 0.09t or more, from the viewpoint of improving the strength. Specifically, for example, when the sheet thickness t is 0.7 mm, DOL is preferably 63 µm or less, more preferably 56 µm or less, and still more preferably 49 µm or less. In addition, DOL is preferably 28 µm or more, still more preferably 35 µm or more, and particularly preferably 42 µm or more. The preferred sheet thickness (t) and preferred shape of the present chemically strengthened glass are the same as the preferred sheet thickness (t) and the preferred shape of the present glass ceramic described above.

### <Method for Producing Glass Ceramic and Chemically Strengthened Glass>

The present chemically strengthened glass can be produced by subjecting the present glass ceramic described above to a chemical strengthening treatment. In addition, the present glass ceramic can be produced by subjecting an amorphous glass to a heat treatment to crystallize the amorphous glass.

### (Production of Amorphous Glass)

The amorphous glass can be produced, for example, by the following method. The production method described below is an example in a case of producing a sheet-shaped glass ceramic and a sheet-shaped chemically strengthened glass.

In order to obtain a glass having preferred composition, glass raw materials are mixed, and then heated and melted in a glass melting furnace. Thereafter, the molten glass is homogenized by bubbling, stirring, addition of a refining agent, or the like and formed into a glass sheet having a predetermined thickness by a known forming method, followed by being annealed. Alternatively, the molten glass may be formed into a block shape, annealed, and then cut into a sheet shape.

Here, preferred glass composition of the amorphous glass is the same as preferred glass composition of the glass ceramic described above.

### (Crystallization Treatment)

The amorphous glass obtained by the above procedure is subjected to a heat treatment to obtain a glass ceramic.

A method of the heat treatment is not particularly limited, but for example, the following method is preferable.

The heat treatment may be a two-stage heat treatment in which the glass is held for a certain period of time (holding time 11) at a temperature raised from room temperature to a first treatment temperature T1, and then is held for a certain period of time (holding time t2) at a second treatment temperature T2 that is higher than the first treatment temperature. Alternatively, the heat treatment may be a one-stage heat treatment in which the glass is held at a specific treatment temperature and then cooled to room temperature.

In the case of the two-stage heat treatment, the first treatment temperature T1 is preferably a temperature range in which a crystal nucleation rate increases in the glass composition, and the second treatment temperature T2 is preferably a temperature range in which a crystal growth rate increases in the glass composition. In addition, the holding time t1 at the first treatment temperature T1 is preferably a relatively long time so that a sufficient number of crystal nuclei are generated. When a large number of crystal nuclei are generated, a size of each crystal is reduced, and a glass ceramic having high transparency is easily obtained.

In the case of the two-stage heat treatment, the first treatment temperature T1 is preferably, for example, 450°C to 700°C, and the holding time t1 is preferably 1 hour to 6 hours. In addition, the second treatment temperature T2 is preferably, for example, 600°C to 800°C, and the holding time t2 is preferably 1 hour to 6 hours. In the case of the one-stage treatment, the glass is preferably held at, for example, 500°C to 800°C for 1 hour to 6 hours.

The molten glass may be homogenized and formed into a glass sheet having a predetermined thickness, or the molten glass may be formed into a block shape and then continuously subjected to a crystallization treatment.

When the sheet-shaped glass is subjected to the heat treatment, examples of a setter board include a silicon carbide board, a silicon nitride board, a SiN board, an alumina board, a mullite cordierite board, a mullite board, and a glass ceramic sheet. In addition, in order to reduce temperature unevenness during heat treatment, a material having high thermal conductivity is preferable. A thermal conductivity of the setter board is preferably 2 W/(m·K) or more, more preferably 20 W/(m K) or more, and still more preferably 40 W/(m·K) or more.

A release agent can be used to prevent the glass from adhering to the setter board. Examples of the release agent include alumina cloth and glass cloth. In addition, for example, powdery boron nitride, alumina, or mineral may be used. The release agent in a powder form may be mixed with a solvent and applied by spraying or the like. When a particulate release agent is used, an average particle size thereof is preferably 80 µm or less, more preferably 50 µm or less, and still more preferably 30 µm or less.

The glass may be laminated in order to increase working efficiency when being subjected to the heat treatment. In a case of lamination, a release agent is preferably used between glass and glass. In addition, a setter board may be placed between glass and glass.

The glass ceramic obtained by the above procedure is subjected to grinding and polishing as necessary to form a glass ceramic sheet. In a case where the glass ceramic sheet is cut into a predetermined shape and size or chamfered, it is preferable to perform cutting or chamfering before performing the chemical strengthening treatment because a compressive stress layer is also formed on an end surface by the subsequent chemical strengthening treatment.

### (Chemical Strengthening Treatment)

The chemical strengthening treatment is a treatment in which a glass is brought into contact with the metal salt by a method such as immersion in a molten solution of a metal salt (for example, potassium nitrate) containing metal ions having a large ion radius, so that metal ions having a small ion radius in the glass are substituted with the metal ions having a large ion radius. Here, the metal ions having a small ion radius are typically Na ions or Li ions. The metal ions having a large ion radius are typically Na ions or K ions, more specifically, Na ions or K ions for Li ions, and K ions for Na ions.

In order to increase a rate of the chemical strengthening treatment, it is preferable to use "Li-Na exchange" in which Li ions in the glass are exchanged with Na ions. In addition, in order to form a large compressive stress by ion exchange, it is preferable to use "Na-K exchange" in which Na ions in the glass are exchanged with K ions.

Examples of the molten salt for performing the chemical strengthening treatment include a nitrate, a sulfate, a carbonate, and a chloride. Examples of the nitrate include lithium nitrate, sodium nitrate, potassium nitrate, cesium nitrate, and silver nitrate. Examples of the sulfate include lithium sulfate, sodium sulfate, potassium sulfate, cesium sulfate, and silver sulfate. Examples of the carbonate include lithium carbonate, sodium carbonate, and potassium carbonate. Examples of the chloride include lithium chloride, sodium chloride, potassium chloride, cesium chloride, and silver chloride. These molten salts may be used alone or in combination.

As the treatment conditions of the chemical strengthening treatment, time, temperature, and the like may be selected in consideration of the glass composition, the type of molten salt, and the like. For example, the present glass ceramic is preferably subjected to the chemical strengthening treatment at 450°C or lower for preferably 1 hour or shorter. Specifically, for example, a treatment of immersion in a molten salt (for example, a mixed salt of lithium nitrate and sodium nitrate) preferably containing 0.3 mass% of Li and 99.7 mass% of Na at 450°C for preferably about 0.5 hours is exemplified.

The chemical strengthening treatment may be, for example, two-stage ion exchange as follows. First, the present glass ceramic is immersed in a metal salt containing Na ions (for example, sodium nitrate) at preferably about 350°C to 500°C for preferably about 0.1 hours to 10 hours. This causes ion exchange between Li ions in the glass ceramic and Na ions in the metal salt, thereby forming a relatively deep compressive stress layer.

Next, the present glass ceramic is immersed in a metal salt containing K ions (for example, potassium nitrate) preferably at about 350°C to 500°C for preferably about 0.1 hours to 10 hours. Accordingly, a large compressive stress is generated in a portion of the compressive stress layer formed in the previous process, for example, within a depth of about 10 µm. By such a two-stage treatment, a stress profile having a large surface compressive stress value is easily obtained.

### (Application)

The present invention relates to an electronic device including the present glass ceramic or the present chemically strengthened glass. That is, the present glass ceramic and the present chemically strengthened glass can implement both high strength and radio wave transmittance, and thus are useful as a cover glass or a circuit board used in an electronic device. The present glass ceramic and the present chemically strengthened glass are particularly useful as a cover glass for use in a mobile device such as a mobile phone, a smart phone, a personal digital assistant (PDA), and a tablet terminal. Further, the present glass ceramic and the present chemically strengthened glass are also useful for applications which are not intended to be carried such as a cover glass of a display device such as a television (TV), a personal computer (PC), and a touch panel, an elevator wall surface, or a wall surface (full-screen display) of a construction such as a house and a building, a building material such as a window glass, a table top, an interior of an automobile, an airplane, or the like, and a cover glass thereof, or a casing having a curved surface shape that is not a sheet shape by bending or forming.

### EXAMPLES

Hereinafter, the present invention will be described in detail with reference to Examples, but the present invention is not limited thereto.

Glass raw materials were mixed so as to have a composition shown in Table 1 in terms of a molar percentage based on oxides, and weighed out to obtain 400 g of a glass. Then, the mixed raw materials were put in a platinum crucible, put into an electric furnace at 1,500°C to 1,700°C, melted for about 3 hours, defoamed, and homogenized.

The obtained molten glass was poured into a metal mold, held at a temperature of approximately 50°C higher than a glass transition point for 1 hour, and then cooled to the room temperature at a rate of 0.5 °C/min, thereby obtaining a glass block. The obtained glass block was cut, ground, and finally mirror-polished on both surfaces to obtain a glass sheet having a thickness of 2 mm (amorphous glass 1 to amorphous glass 6).

Each obtained amorphous glass was subj ected to a heat treatment. That is, the amorphous glasses 1 to 6 were first heated to the first treatment temperature T1 at the heating rate described in Table 2. Then, the glass was held at the first treatment temperature T1 for the holding time t1, thereby being subjected to the first-stage heating treatment. By the first-stage heat treatment, crystal nucleus are formed over an entire volume of the starting glass. After the first-stage heat treatment, a precursor (amorphous glass after first-stage heat treatment) was heated to the second-stage treatment temperature T2 at the heating rate shown in Table 2. Then, the glass was held at the second treatment temperature T2 for the second holding time t2, thereby being subjected to the second-stage heating treatment. Crystals grow by the second-stage heat treatment and the crystallization rate increases.

The amorphous glass shown in Table 1 was subjected to a heat treatment under the conditions shown in Table 2 to obtain glass ceramics according to Examples 1 to 6. In addition, physical properties described in Table 2 were obtained from the obtained glass ceramic. The glass ceramics according to Examples 1 to 4 are inventive examples, and the glass ceramics according to Examples 5 and 6 are comparative examples.

Methods for measuring the physical properties are shown below.

### (Radio Wave Transmittance of glass ceramic)

The glass ceramic was processed into a rectangular parallelepiped having a length of 30.0 mm, a width of 30.0 mm, and a thickness of 0.5 mm, and surfaces of 30.0 mm × 30.0 mm were mirror-polished. The relative dielectric constant Dk and the dielectric loss tangent tan δ at 20°C and 10 GHz were measured using a network analyzer by a slip post dielectric resonance method (SPDR method).

### (Chemical Strengthening Properties)

Each glass ceramic was immersed in a salt of 100% sodium nitrate at 450°C for 1 hour to perform chemical strengthening. The surface compressive stress value CS and the compressive stress depth DOL after the chemical strengthening were measured using a scattered light photoelastic stress meter SLP-1000 manufactured by Orihara Industrial Co., Ltd.

### (PXRD Measurement of Glass Ceramic)

The obtained glass ceramic was subjected to PXRD measurement by the following procedure to identify crystal types.

### (Preparation Conditions of PXRD Measurement Sample)

The glass ceramic sheet subjected to the SPDR method was pulverized using an agate mortar and an agate pestle, thereby obtaining a powder for PXRD measurement.

### (PXRD Measurement Conditions)

Powder X-ray diffraction was measured under the following conditions to identify precipitated crystals.

For identification of crystal types, a diffraction peak pattern recorded in an ICSD inorganic crystal structure database and an ICDD powder diffraction database was used.
Measurement device: SmartLab manufactured by Rigaku Corporation
Measurement method: concentration method
Tube voltage: 45 kV
Tube current: 200 mA
X-ray to be used: CuKα ray
Measurement range: 2θ = 10° to 80°
Speed: 10°/min
Step: 0.02°

### (Preparation Conditions of Rietveld Measurement Sample)

After a glass ceramic powder used in the PXRD measurement was passed through a mesh having an opening of 500 µm, ZnO was added as a standard substance so as to be 10 mass% of the entire sample.

### (Rietveld Analysis Conditions)

The powder X-ray diffraction was measured under the following conditions, and Rietveld analysis was performed using obtained results.
Measurement device: SmartLab manufactured by Rigaku Corporation
Measurement method: concentration method
Tube voltage: 45 kV
Tube current: 200 mA
X-ray to be used: CuKα ray
Measurement range: 2θ = 10° to 90°
Speed: 5°/min
Step: 0.01°

A powder X-ray diffraction profile obtained under the above conditions was analyzed using a Rietveld analysis program: Rietan FP. The analysis of each sample was converged so that Rwp representing quality of analysis convergence was 10 or less. The Rietveld method is described in "Crystal Analysis Handbook" edited by the Crystallographic Society of Japan "Crystal Analysis Handbook" editorial committee (Kyoritsu Shuppan, 1999, p492-499).

### (Calculation of Precipitation Ratio of Each Crystal)

A precipitation ratio (content ratio) of each crystal was calculated by subtracting the added 10 mass% of ZnO from a weight ratio of the crystal phase obtained by Rietveld analysis and a remaining glass phase obtained by subtracting the content of the crystal phase from a total amount of the measurement sample, and making a total content of the remaining phase 100 mass%. In addition, a total precipitation ratio of each crystal represents the degree of crystallinity of the glass ceramic.

**Table 1**

| (mol%) | Amorphous glass 1 | Amorphous glass 2 | Amorphous glass 3 | Amorphous glass 4 | Amorphous glass 5 | Amorphous glass 6 |
|---|---|---|---|---|---|---|
| SiO₂ | 75.0 | 75.1 | 74.6 | 75.0 | 70.1 | 710 |
| Al₂O₃ | 3.0 | 4.3 | 3.0 | 10 | 4.3 | 4.5 |
| B₂O₃ | 10 | 0.0 | 0.0 | 0.0 | 0.2 | 0.0 |
| P₂O₅ | 0.8 | 0.8 | 1.4 | 2.5 | 0.8 | 0.8 |
| MgO | 0.0 | 0.0 | 0.0 | 2.5 | 0.0 | 0.0 |
| CaO | 0.0 | 0.0 | 0.0 | 2.0 | 0.0 | 0.0 |
| ZrO₂ | 0.0 | 0.0 | 0.0 | 0.0 | 1.8 | 2.1 |
| Li₂O | 18.7 | 18.0 | 19.0 | 150 | 21.4 | 21.2 |
| Na₂O | 1.5 | 1.5 | 2.0 | 0.0 | 1.5 | 0.3 |
| K₂O | 0.0 | 0.3 | 0.0 | 2.0 | 0.0 | 0.1 |
| Sum | 100.0 | 100.0 | 100.0 | 100.0 | 100.0 | 100.0 |

**Table 2**

| Glass Ceramic | Example 1 | Example 2 | Example 3 | Example 4 | Example 5 | Example 6 |
|---|---|---|---|---|---|---|
| Number of amorphous glass | 1 | 2 | 3 | 4 | 5 | 6 |
| Crystallization condition | | | | | | |
| Heating rate to T1 [K/min] | 5 | 5 | 5 | 5 | 5 | 5 |
| Temperature T1 [°C] | 540 | 590 | 570 | 630 | 600 | 600 |
| Holding time t1 [h] | 4.0 | 4.0 | 4.0 | 4.0 | 4.0 | 4.0 |
| Heating rate to T2 [K/min] | 5 | 5 | 5 | 5 | 5 | 5 |
| Temperature T2 [°C] | 710 | 715 | 730 | 710 | 710 | 710 |
| Holding time t2 [h] | 4.0 | 4.0 | 4.0 | 4.0 | 4.0 | 4.0 |
| Precipitated crystal ratio (mass%) | | | | | | |
| Lithium disilicate-based | 50% | 30% | 35% | 20% | 35% | 35% |
| Petalite-based | 10% | 20% | 15% | 0% | 35% | 35% |
| SiO₂-based | 20% | 20% | 25% | 40% | 0% | 0% |
| Property | | | | | | |
| CS [MPa] | 50 | 50 | 50 | 60 | 135 | 130 |
| DOL [µm] | 60 | 50 | 70 | 40 | 90 | 80 |
| Relative dielectric constant Dk@20°C, 10 GHz | 4.91 | 5.06 | 4.93 | 5.37 | 5.69 | 5.51 |
| Dielectric loss tangent tan δ@20°C, 10 GHz | 0.0037 | 0.0080 | 0.0049 | 0.0077 | 0.0057 | 0.0051 |

A precipitated crystal ratio in the table indicates the precipitation ratio of each crystal (content ratio) calculated using Rietveld analysis in terms of mass percentage relative to the total amount of the glass ceramic. In the glass ceramics according to Examples 1 to 3, the SiO₂-based crystal is cristobalite. In the glass ceramic according to Example 4, the SiO₂-based crystal is quartz.

CS and DOL in the table respectively represent the surface compressive stress value CS and the compressive stress depth DOL of the chemically strengthened glass subj ected to the above-described chemical strengthening for each glass ceramic. In the table, a blank column indicates that evaluation is not performed.

In the glass ceramics according to Examples 1 to 4, which are inventive examples, the content of the lithium disilicate-based crystal and the content of SiO₂-based crystal are both equal to or greater than the content of other crystals. As a result, it is confirmed that the glass ceramics according to Examples 1 to 4 have the relative dielectric constant Dk at 20°C and 10 GHz of 5.4 or less and the value of the dielectric loss tangent tan δ of 0.01 or less, which are very good values, and have good radio wave transmittance. In addition, in the glass ceramics according to Examples 1 to 4, a compressive stress of 25 MPa or more can be provided to a surface layer by chemical strengthening. That is, the glass ceramics according to Examples 1 to 4 have excellent chemical strengthening properties and can impart a high strength by chemical strengthening.

On the other hand, the glass ceramics according to Examples 5 and 6 contain a lithium disilicate-based crystal, but do not contain a SiO₂-based crystal, and contain a Petalite-based crystal as other crystals. As a result, the glass ceramics according to Examples 5 and 6 have a relative dielectric constant Dk of more than 5.5 and are inferior in radio wave transmittance.

As described above, the following matters are disclosed in the present description.
1. A glass ceramic including:
   a lithium disilicate-based crystal; and
   an SiO₂-based crystal, in which
   a content of the lithium disilicate-based crystal and a content of the SiO₂-based crystal are both equal to or greater than a content of crystal other than the lithium disilicate-based crystal and the SiO₂-based crystal on a mass basis.
2. The glass ceramic according to 1, in which
   the content of the lithium disilicate-based crystal is equal to or greater than the content of the SiO₂-based crystal on a mass basis.
3. The glass ceramic according to 1 or 2, including 20 mass% or more of the lithium disilicate-based crystal.
4. The glass ceramic according to any one of 1 to 3, including 20 mass% or more of the SiO₂-based crystal.
5. The glass ceramic according to any one of 1 to 4, having a degree of crystallinity of 50 mass% or more.
6. The glass ceramic according to any one of 1 to 5, having relative dielectric constant Dk at 20°C and 10 GHz of 5.4 or less.
7. The glass ceramic according to any of 1 to 6, having a dielectric loss tangent tan δ at 20°C and 10 GHz of 0.01 or less.
8. The glass ceramic according to any one of 1 to 7, including, in terms of molar percentage based on oxides:
   70% to 80% of SiO₂;
   1% to 5% of Al₂O₃;
   0% to 5.0% of B₂O₃;
   0.5% to 5.0% of P₂O₅;
   0% to 5.0% of TiO₂;
   0% to 1.0% of ZrO₂;
   15% to 25% of Li₂O;
   0% to 5.0% of Na₂O;
   0% to 5.0% of K₂O; and
   0% to 5.0% in total of one or more selected from MgO, CaO, SrO, and BaO.
9. The glass ceramic according to any one of 1 to 7, including, in terms of molar percentage based on oxides:
   70% to 80% of SiO₂;
   1% to 5% of Al₂O₃;
   0% to 5.0% of B₂O₃;
   0.5% to 5.0% of P₂O₅;
   0% to 5.0% of TiO₂;
   0% to 1.0% of ZrO₂;
   15% to 25% of Li₂O;
   0% to 5.0% of Na₂O;
   0% to 5.0% of K₂O;
   0.1% to 10% of a total amount of Na₂O and K₂O; and
   0% to 5.0% in total of one or more selected from MgO, CaO, SrO, and BaO.
10. A chemically strengthened glass having a compressive stress layer on a surface thereof,
   having a surface compressive stress value CS of 25 MPa or more, and
   being the glass ceramic according to any one of 1 to 9.
11. The chemically strengthened glass according to 10, having a sheet shape, in which
   a content ratio of an alkaline metal element is different between a surface layer and a center in a thickness direction.
12. An electronic device including the glass ceramic according to any one of 1 to 9 or the chemically strengthened glass according to 10 or 11.

Although the present invention has been described in detail with reference to specific embodiments, it is obvious to those skilled in the art that various changes and modifications can be made without departing from the spirit and scope of the present invention.

The present application is based on a Japanese Patent Application (No. 2021-143382) filed on September 2, 2021, the contents of which are incorporated herein by reference.

### INDUSTRIAL APPLICABILITY

The present glass ceramic and the present chemically strengthened glass can implement both high strength by chemical strengthening and radio wave transmittance, and thus are useful as a cover glass or a circuit board used in an electronic device. The present glass ceramic and the present chemically strengthened glass are particularly useful as a cover glass for use in a mobile device such as a mobile phone, a smart phone, a personal digital assistant (PDA), and a tablet terminal. Further, the present glass ceramic and the present chemically strengthened glass are also useful for applications which are not intended to be carried such as a cover glass of a display device such as a television (TV), a personal computer (PC), and a touch panel, an elevator wall surface, or a wall surface (full-screen display) of a construction such as a house and a building, a building material such as a window glass, a table top, an interior of an automobile, an airplane, or the like, and a cover glass thereof, or a casing having a curved surface shape that is not a sheet shape by bending or forming.

## Claims

1. A glass ceramic comprising:
a lithium disilicate-based crystal; and
an SiO₂-based crystal, wherein
a content of the lithium disilicate-based crystal and a content of the SiO₂-based crystal are both equal to or greater than a content of crystal other than the lithium disilicate-based crystal and the SiO₂-based crystal on a mass basis.

2. The glass ceramic according to claim 1, wherein
the content of the lithium disilicate-based crystal is equal to or greater than the content of the SiO₂-based crystal on a mass basis.

3. The glass ceramic according to claim 1 or 2, comprising 20 mass% or more of the lithium disilicate-based crystal.

4. The glass ceramic according to claim 1 or 2, comprising 20 mass% or more of the SiO₂-based crystal.

5. The glass ceramic according to claim 1 or 2, having a degree of crystallinity of 50 mass% or more.

6. The glass ceramic according to claim 1 or 2, having a relative dielectric constant Dk at 20°C and 10 GHz of 5.4 or less.

7. The glass ceramic according to claim 1 or 2, having a dielectric loss tangent tan δ at 20°C and 10 GHz of 0.01 or less.

8. The glass ceramic according to claim 1 or 2, comprising, in terms of molar percentage based on oxides:
70% to 80% of SiO₂;
1% to 5% of Al₂O₃;
0% to 5.0% of B₂O₃;
0.5% to 5.0% of P₂O₅;
0% to 5.0% of TiO₂;
0% to 1.0% of ZrO₂;
15% to 25% of Li₂O;
0% to 5.0% of Na₂O;
0% to 5.0% of K₂O; and
0% to 5.0% in total of one or more selected from MgO, CaO, SrO, and BaO.

9. The glass ceramic according to claim 1 or 2, comprising, in terms of molar percentage based on oxides:
70% to 80% of SiO₂;
1% to 5% of Al₂O₃;
0% to 5.0% of B₂O₃;
0.5% to 5.0% of P₂O₅;
0% to 5.0% of TiO₂;
0% to 1.0% of ZrO₂;
15% to 25% of Li₂O;
0% to 5.0% of Na₂O;
0% to 5.0% of K₂O;
0.1% to 10% of a total amount of Na₂O and K₂O; and
0% to 5.0% in total of one or more selected from MgO, CaO, SrO, and BaO.

10. A chemically strengthened glass having a compressive stress layer on a surface thereof,
having a surface compressive stress value CS of 25 MPa or more, and
being the glass ceramic according to claim 1 or 2.

11. The chemically strengthened glass according to claim 10, having a sheet shape, wherein
a content ratio of an alkaline metal element is different between a surface layer and a center in a thickness direction.

12. An electronic device comprising the glass ceramic according to claim 1.
